# EUROPÄISCHE PATENTANMELDUNG

(11) **EP 1 126 475 A2**
(43) Veröffentlichungstag der Anmeldung: **22.08.2001**
(21) Anmeldenummer: 01103000.4
(22) Anmeldetag: 08.02.2001
(51) Int. Cl.: G11C 29/00, G06F 11/22

(54) **Verfahren und Vorrichtung zum Testen eines als Arbeitsspeicher im Personal Computer eingesetzten SDRAM-Speichers**

(30) Priorität: 17.02.2000 DE 10007177
(71) Anmelder: Infineon Technologies AG, 81669 München (DE)
(72) Erfinder: Doll, Andreas, 85579 Neubiberg (DE); Moser, Manfred, 85221 Dachau (DE); Schramm, Achim, 81825 München (DE)
(74) Vertreter: MÜLLER & HOFFMANN Patentanwälte

(57) **Zusammenfassung**

Die Erfindung betrifft ein Verfahren und eine Vorrichtung zum Testen eines als Arbeitsspeicher im PC eingesetzten SDRAMs (8) mittels einer zusätzlichen, auf einer Steckkarte (21) untergebrachten Schaltungsanordnung, die einen Zusatzspeicher (22) in Form eines SRAM und Logikschaltkreise (23 und 24) aufweist. Mit dem erfindungsgemäßen Verfahren kann gezielt das zu testende SDRAM (8) einer Modulbank im laufenden PC in einen Testmodus gesetzt werden. Hierbei wird der Code zur Testmodeaktivierung von einem Hochsprachenprogramm (PASCAL) entsprechend den Benutzervorgaben modifiziert, in den Zusatzspeicher (22) auf der Steckkarte (21) kopiert und dann vom Hochsprachenprogramm unter MS DOS aufgerufen. Nach der Aktivierung des gewählten Testmodus durch den in Assembler programmierten Code erfolgt wieder ein definierter Rücksprung ins aufrufende Programm. Die Erfindung ermöglicht erstmals den Einsatz der im SDRAM vorgesehenen Testmodes in Standard-PCs und unter Standardbetriebssystemen. Dadurch werden die Testmöglichkeiten von SDRAMs auf Standard-PCs stark erweitert.

## Beschreibung

Die vorliegende Erfindung betrifft ein Verfahren und eine Vorrichtung zum Test eines als Arbeitsspeicher im Personal Computer eingesetzten SDRAM-Speichers und befaßt sich insbesondere mit der Aktivierung und Ausführung von im SDRAM-Speicher herstellerseitig definierten und vorbestimmten chip-internen Testmodi in der normalen Anwendung des SDRAM-Speichers als Arbeitsspeicher im PC.

Verschiedene Hersteller von SDRAMs integrieren in ihre Bausteine spezielle Funktionen (Testmodi), die ein effizienteres Testen des SDRAMs ermöglichen. Diese Testmodi konnten bisher nur auf speziellen Testgeräten aktiviert, nicht aber unter den typischen Einsatzbedingungen der SDRAMs in einem Computer ausgeführt werden.

Besonders schwierig gestalteten sich Tests von SDRAMs, die im Rechner zu sporadischen Ausfällen führten. Derartige sporadische Ausfälle können auf dem Testgerät nicht oder selten bestätigt werden.

Es ist deshalb Aufgabe der Erfindung, ein Verfahren und eine Vorrichtung zum Test eines als Arbeitsspeicher im PC eingesetzten SDRAM-Speichers durch Aktivierung wenigstens eines im SDRAM implementierten Testmodus so anzugeben, daß dieser Testmodus auch im Standardbetrieb des SDRAMs im Computer aktivierbar und durchführbar ist, um so einen effizienteren Test des SDRAMs in seiner normalen Anwendung als Arbeitsspeicher im PC zu ermöglichen.

Diese Aufgabe wird anspruchsgemäß gelöst.

Gemäß einem ersten Aspekt ist ein erfindungsgemäßes Verfahren zum Testen eines als Arbeitsspeicher im Personal Computer eingesetzten SDRAMs gekennzeichnet durch die folgenden Schritte:
A) Speichern wenigstens einer zur Aktivierung und Durchführung wenigstens eines der internen Testmodi geeigneten Befehlsfolge im Maschinencode in einem vom Arbeitsspeicher separaten Zusatzspeicher;
B) im PC wird der Maschinencode aktiviert und der CACHE-Speicher abgeschaltet;
C) die CPU wird in den UNREAL-MODE versetzt, wobei die Datensegmentierung des Arbeitsspeichers aufgehoben wird;
D) im PC werden für eine Aktivierungssequenz des Testmodus im SDRAM vorbestimmte Einstellungen des PC-Chipsatzes durchgeführt;
E) benutzerdefiniert wird ein gewünschter Testmodus von den im SDRAM-Speicher implementierten Testmodi ausgewählt und daraufhin ein Lese-Zugriff auf den separaten Zusatzspeicher zur Ausführung der Befehlsfolge für die Aktivierung des Testmodus ausgeführt, wobei ;
F) der Testmodus durch eine bestimmte Sequenz von Kommandos und Adressen vom Speichercontroller an den SDRAM-Speicher aktiviert wird, die durch die Befehlsfolge im Zusatzspeicher gesteuert wird, und
G) Testergebnisse werden protokolliert.

Das erfindungsgemäße Verfahren ermöglicht es, alle im SDRAM implementierten Testmodi im Standard-PC unter Standardbetriebssystemen durchzuführen. Dadurch werden die Testmöglichkeiten von SDRAMs auf Standard-PCs stark erweitert. Darüber hinaus bieten die verschiedenen, im SDRAM implementierten Testmodi erstmals die Möglichkeit, verschiedene bausteininterne Parameter, wie Spannungen, Timings, gezielt zu variieren, während der SDRAM im PC arbeitet, um in dieser normalen Umgebung des SDRAMs im Standardrechner die eigentliche Ursache des Fehlers zu analysieren.

Nach der Ausführung des zuvor aktivierten Testmodus und Protokollierung der Testergebnisse werden die im Schritt D) vorgenommenen Einstellungen des PC-Chipsatzes rückgängig gemacht, die Datensegmentierung des Arbeitsspeichers durch Versetzen der CPU in den REAL-MODE wiederhergestellt, der CACHE-Speicher wieder eingeschaltet und es erfolgt ein Rücksprung ins aufrufende Programm, wobei der SDRAM-Speicher im gewählten Testmodus bleibt, so daß dessen Auswirkung dem SDRAM-Speicher erhalten bleibt. Mit einem durch diese Auswirkung im SDRAM-Speicher veränderten Parameter kann dann entweder der normale Arbeitsspeicherbetrieb oder eine beliebige im PC implementierte Prüfsoftware initiiert werden.

Somit ermöglicht das erfindungsgemäße Verfahren nicht nur eine verbesserte Analyse bzw. einen verbesserten Test von SDRAM-Bausteinen in deren normaler Umgebung im PC sondern es können auch SDRAM-Chips in ihrer Auslegung verbessert werden. Z. B. ist es möglich, verschiedene Timings mit Hilfe der Testmodi im System zu testen, um die optimale Einstellung für ein endgültiges Design des Chips zu verwenden. Somit kann durch das Verändern bausteininterner Parameter der Chip so weit optimiert werden, dass eine optimale Funktion des Chips im Standardrechner gewährleistet ist, und dann diese Einstellung für ein endgültiges Chipdesign verwendet wird.

Eine Anwendung des erfindungsgemäßen Verfahrens besteht auch darin, die Ausfallrate eines SDRAM-Chips im Rechner systematisch zu erhöhen oder zu verringern. Das Verhalten des Chips liefert Hinweise darauf, wie die Testprogramme im Testgerät modifiziert werden müssen, damit die Ausfälle auch im Testgerät nachvollzogen werden können. Durch weitergehendes Variieren interner Parameter des SDRAM-Bausteins kann die eigentliche Fehlerursache weiter eingegrenzt und vollständig analysiert werden.

Mit dem erfindungsgemäßen Verfahren ist somit ein neues und vorteilhaftes Werkzeug zur Analyse von SDRAM-Bausteinen in ihrer einsatzgemäßen Umgebung erzielt.

Z. B. ist ein mit dem erfindungsgemäßen Verfahren aktivierbarer Testmodus ein SET-V-REF genannter Testmodus, der die Veränderung der internen Referenzspannung V_{ref} eines SDRAM-Chips ermöglicht.

Ein weiterer mit dem erfindungsgemäßen Verfahren ausführbarer Testmodus für einen im PC eingesetzten SDRAM-Chip besteht darin, im SDRAM eine interne Zeitdauer zwischen dem Aktivieren der Wortleitung und dem Aktivieren des zugehörigen Sense-Verstärkers zu verändern.

Um die Testmodi im Arbeitsspeicher des PC, d. h. im SDRAM aktivieren zu können, wird der vom Hauptspeicher unabhängige Zusatzspeicher für den Programmablauf im PC benötigt.

Eine erfindungsgemäße zur Durchführung des Verfahrens eingerichtete Vorrichtung ist dadurch gekennzeichnet, dass der Zusatzspeicher mit einer Codierlogik auf einer Steckkarte vorgesehen ist. Diese Steckkarte kann z. B. in einen Steckplatz des ISA-Busses im PC gesteckt sein. Statt dessen kann es sich bei der Steckkarte z. B. auch um eine PCI-Steckkarte handeln. Mit dieser Schaltungsanordnung wird somit die Sequenz zur Aktivierung der Testmodi im Maschinencode ausgeführt.

Unter Verwendung der auf dieser Steckkarte gespeicherten Befehlsfolge lässt sich gezielt das in einer Modulbank im Arbeitsspeicher befindliche SDRAM im laufenden PC in einen von mehreren wählbaren Testmodi versetzen. Hierbei wird der Maschinencode zur Aktivierung des Testmodus von einem Hochsprachenprogramm entsprechend an einer Benutzerschnittstelle vorgegebenen Benutzerbefehlen modifiziert, in den Zusatzspeicher kopiert und dann vom Hochsprachenprogramm unter MS DOS aufgerufen. Nach der Aktivierung des gewählten Testmodus durch den Maschinencode erfolgt wieder ein definierter Rücksprung in das aufrufende Programm.

Das erfindungsgemäße Verfahren und die erfindungsgemäße zur Durchführung des Verfahrens eingerichtete Vorrichtung wird in der nachfolgenden Beschreibung anhand der Zeichnung näher erläutert. Es zeigen:
- Fig. 1: in Form eines Blockschaltbilds Funktionsblöcke eines handelsüblichen Personal Computers, in dem sich das erfindungsgemäße Verfahren mit einer zur Durchführung des Verfahrens eingerichteten Vorrichtung durchführen lässt;
- Fig. 2: ein Ablaufdiagramm zur Erläuterung der für die Aktivierung aller Testmodi wesentlichen Schritte des erfindungsgemäßen Verfahrens;
- Fig. 3: graphisch Ausfallraten von SDRAM-Modulen, die sich beim ersten Testmodus bei der Veränderung der internen Spannung ergaben;
- Fig. 4: graphisch Ausfallraten, die sich bei der Durchführung eines zweiten Testmodus, bei dem mittels des erfindungsgemäßen Verfahrens ein internes Timing des SDRAM-Chips verändert wird, einstellten; und
- Fig. 5: ein Funktionsblockschaltbild mit einer eine zur Durchführung des erfindungsgemäßen Verfahrens eingerichtete Schaltungsanordnung aufweisenden ISA-Steckkarte.

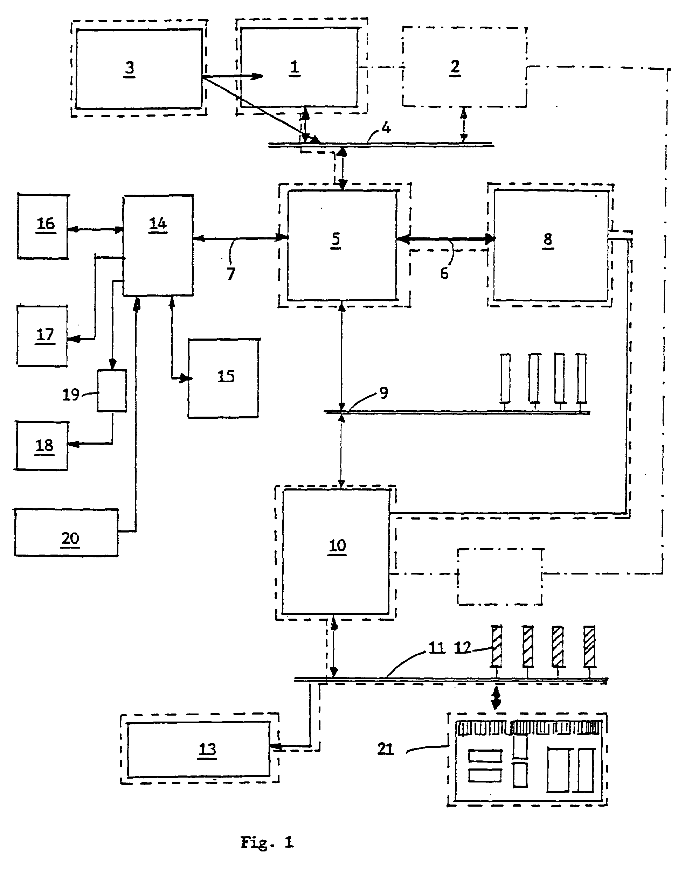

Vor der Erläuterung des erfindungsgemäßen Verfahrens und zweier Anwendungsbeispiele desselben sowie der zur Durchführung des Verfahrens eingerichteten Vorrichtung werden nachstehend zunächst anhand der Fig. 1 zum Verständnis der Erfindung dienende Funktionsblöcke eines üblichen Personal Computers erläutert. Die für das erfindungsgemäße Verfahren wesentlichen Funktionsblöcke sind in Fig. 1 mit gestrichelten Linien umrandet.

Ein Prozessorblock 1 mit zugehörigem CACHE 3 verkehrt über einen HOST-Bus 4 und eine HOST-Bridge 5 einerseits mit einem Hauptspeicher 8, der zu prüfende SDRAMs enthält sowie über einen PCI-Bus 9 mit in PCI-Steckplätzen einsteckbaren (nicht gezeigten) PCI-Komponenten.

Die HOST-Bridge ("Northbridge") 5 ist verantwortlich für
- die Berechnung von 32-Bit-Adressen in Zeilen-, Spalten- und Bankadressen (Adressenmultiplex);
- die Steuerung der SDRAMs mit Steuersignalen CS, RAS, CAS, usw.;
- die Betriebsart des SDRAMs; sowie
- eine Entscheidung, welche Modulbank für einen momentanen Task zu verwenden ist.

Zunächst wird aus diesen Hauptfunktionen eines PC deutlich, dass sich der Testmodus eines SDRAM nicht unter Verwendung eines aus dem SDRAM stammenden Aktiviercodes aktivieren lässt.

Deshalb wird im Ausführungsbeispiel eine Schaltungsanordnung auf einer Steckkarte 21 verwirklicht, die in einen der ISA-Steckplätze 12 steckbar ist, und die über den ISA-Bus und eine PCI-ISA-Brücke 10, den PCI-Bus 9 und die HOST-Bridge 5 mit dem Prozessor 1 und dem Arbeitsspeicher 8 kommunizieren kann. Auf dem auf der ISA-Steckkarte befindlichen Zusatzspeicher wird die zur Aktivierung des Testmodus dienende Codesequenz zwischengespeichert. An dem ISA-Bus 11 ist außerdem der System-BIOS-Block 13 angeschlossen.

Es ist zu erwähnen, dass die obige Beschreibung der Fig. 1, die zum Verständnis der erfindungsgemäßen Verfahrensschritte notwendigen Funktionsblöcke eines handelsüblichen Personal Computers anführte. Weitere Komponenten, wie z. B. ein Parallelprozessor 2, können vorgesehen sein, sind jedoch zum Verständnis der Erfindung nicht notwendig. Weitere mögliche Funktionsblöcke sind ein über einen AGP-Bus 7 an der HOST-Bridge 5 angebundener Graphikblock 14, ein Graphikspeicher 15, eine Video-, DVD-, Kameraeinrichtung, VCR-Einrichtung 16, ein Display 17, ein Fernsehmonitor 18, ein Codierer 19 und ein Video-BIOS 20.

Unter Verwendung der eingesteckten Steckkarte (z. B. ISA-Karte mit 16 Bit breitem Datenzugriff, die zwei SRAM-Speicherbausteine als Zusatzspeicher und Decodierlogikbausteine enthält), lässt sich ein SDRAM einer Modulbank im laufenden Personal Computer gezielt in einen gewünschten Testmodus versetzen. Dazu wird der Maschinencode zur Aktivierung des Testmodus von einem Hochsprachenprogramm entsprechend den Benutzervorgaben modifiziert und in den Zusatzspeicher kopiert und dann vom Hochsprachenprogramm unter MS DOS aufgerufen. Nach der Aktivierung des gewählten Testmodus durch den Maschinencode erfolgt wieder ein definierter Rücksprung in das aufrufende Programm.

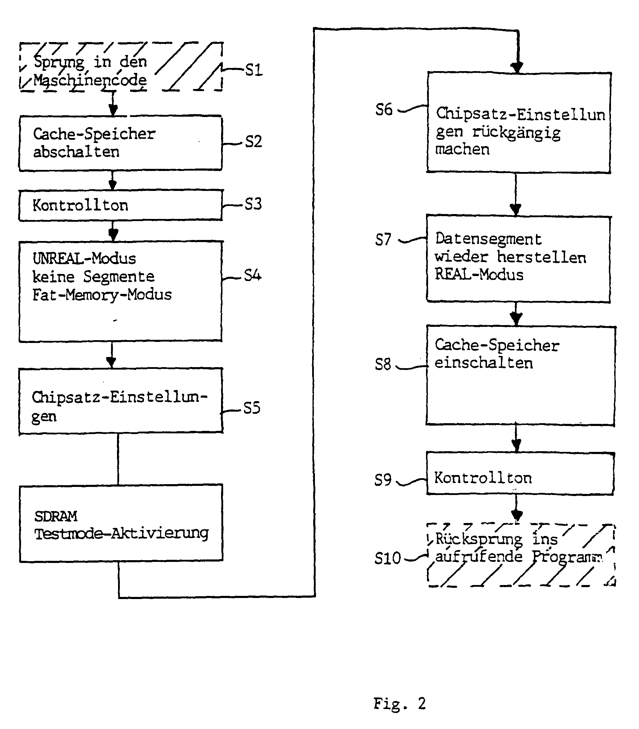

Nachstehend werden die grundsätzlichen Schritte zur Aktivierung eines im Arbeitsspeicher des PCs befindlichen SDRAM anhand des in Fig. 2 gezeigten Ablaufdiagramms beschrieben.

Zunächst erfolgt ein Sprung in den Maschinencode (Schritt S₁). In einem zweiten Schritt S₂ wird der CACHE-Speicher 3 abgeschaltet. Dann wird im Schritt S₃ ein die Aktivierung eines Testmodus angebender Kontrollton an einer akustischen Ausgabevorrichtung (Lautsprecher) ausgegeben. Mit dem Schritt S₄ wird die Speicherorganisationsform des PCs vorübergehend auf den im normalen PC-Betrieb unüblichen "UNREAL-Mode" eingestellt, um direkt auf den gesamten Adressraum des dann unsegmentierten Hauptspeichers zugreifen zu können.

Weiterhin werden im Schritt S₅ verschiedene Einstellungen des Chipsatzes im PC passend verändert.

Nach der Aktivierung des Testmodes und der Durchführung des SDRAM-Tests werden die Einstellungen des Chipsatzes im Schritt S₆ wieder rückgängig gemacht. Im Schritt S₇ wird die Datensegmentierung des PC-Speichers wieder hergestellt: Dies bedeutet REAL-Mode des Arbeitsspeichers. Im Schritt S₈ wird der CACHE-Speicher 3 wieder eingeschaltet und es erfolgt daraufhin ein Kontrollton S₉ am Lautsprecher. Im Schritt S₁₀ erfolgt ein Rücksprung ins aufrufende Programm, wobei das SDRAM im gewählten Testmodus verbleibt.

Nachstehend wird ein erstes Beispiel des SET-V-REF-Testmodus und weiter unten ein zweites Testmodusbeispiel für die Fehleranalyse durch Signal Development Timing beschrieben.

Der SET-V-REF Testmodus verändert intern die Spannung V_{ref} des SDRAM-Chips. Diese Spannung V_{ref} ist die Referenzspannung, aus der sich intern alle anderen Spannungen des Chips ableiten.

Als Messobjekt diente ein 64-M-SDRAM-Modul, welches bei Raumtemperatur durch den Test mit einem Speichertestprogramm eine Reihe von Fehlern anzeigte. Dieses SDRAM-Modul wurde nun durch Variation der bausteininternen Spannung V_{ref} bei konstanter Raumtemperatur von 27 °C im PC analysiert.

Dabei wurde folgendermaßen vorgegangen.

Durch Aktivierung des Testmodus SET-V-REF wurde die Spannung gegenüber dem Standardwert erhöht bzw. erniedrigt. Nach jeder Spannungsänderung wurde ein Speichertestprogramm an diesem SDRAM-Modul ausgeführt und dabei die Anzahl der aufgetretenen Fehler dokumentiert.

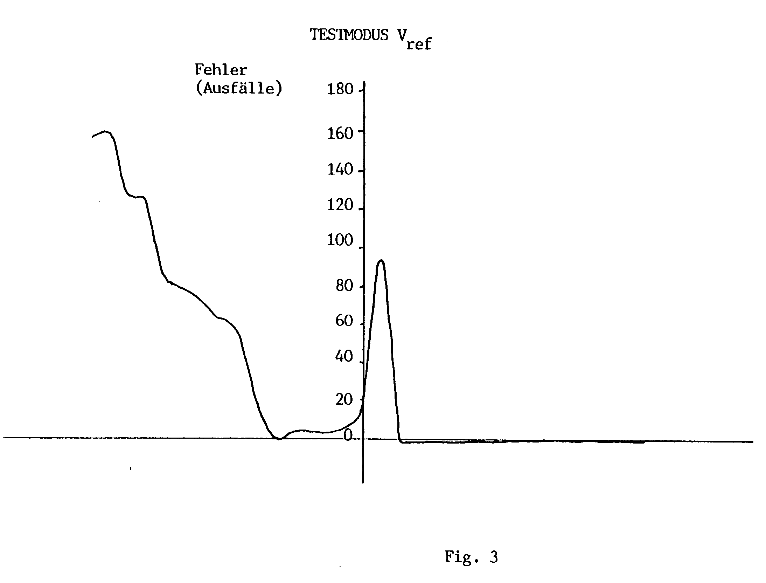

Die Ergebnisse der Auswertung sind in der graphischen Darstellung der Fig. 3 wiedergegeben. Somit wäre es bei diesem Chip sinnvoll, die Referenzspannung V_{ref} um ca. 50 mV zu erhöhen, da dann kein einziger Fehler in der Anwendung des SDRAM-Bausteins mehr auftrat. Die durch die Analyse des im PC mit dem SDRAM-Baustein durchgeführten Testmodus ergibt somit, dass sich der Speicherchip durch eine entsprechende Erhöhung der Referenzspannung V_{ref} um 50 mV im endgültigen Chipdesign verbessern lässt.

Als zweites Beispiel für einen der oben erwähnten Testmodi wird nun eine Fehleranalyse durch Signal Development Timing beschrieben.

Zum Verständnis der Signal Development Time soll zunächst kurz erläutert werden, wie die in einem SDRAM abgespeicherte Information ausgelesen wird. Eine binäre Information (Bit) ist in Form einer Ladung in einem Kondensator gespeichert, der eine Speicherzelle definiert. Soll der Inhalt einer solchen Speicherzelle abgefragt werden, wird durch das Aktivieren einer sogenannten Wortleitung ein Auswahltransistor geöffnet, der die Speicherzelle mit einer sogenannten Bit-Leitung verbindet. Die Ladung fließt aus der Speicherzelle auf die Bit-Leitung und bewirkt dort - je nach dem Informationsinhalt der Zelle - eine positive oder negative Spannungsänderung. Diese Spannungsänderung auf der Bit-Leitung ist jedoch zu gering, um eine direkte Weiterverarbeitung mit Logikgattern zu erlauben. Daher muss ein sogenannter Sense-Verstärker das Signal auf der Bit-Leitung verstärken und auf Logikpegel bringen.

Unter "Signal Development Time" versteht man die Zeitdauer, die zwischen dem Aktivieren der Wortleitung und dem Aktivieren des zugehörigen Sense-Verstärkers liegt. Diese Zeitdauer ist für die Funktion des SDRAMs kritisch: wählt man sie zu lange, verschlechtert sich die sogenannte Zugriffszeit des SDRAMs, was die maximale Arbeitsgeschwindigkeit begrenzt.

Wählt man die Signal Development Time zu kurz, besteht die Gefahr, dass die Ladung der Speicherzelle noch nicht vollständig auf die Bit-Leitung geflossen ist, und der zu früh aktivierte Sense-Verstärker die Pegel der Bit-Leitung falsch interpretiert, wodurch die falsche Information ausgelesen wird. Die Signal Development Time ist nur durch innere Parameter des SDRAM-Chip bestimmt und kann ohne den Einsatz des Testmodus nicht extern beeinflusst werden.

Bestimmte Fehler im Zellenfeld des SDRAMs reagieren besonders empfindlich auf Änderungen der Signal Development Time. Hat z. B. der Kontakt einer Speicherzelle zur Bit-Leitung einen höheren Widerstand als vorgesehen, wird eine längere Zeitdauer benötigt, um die Ladung aus der Speicherzelle auf der Bit-Leitung zu verteilen. Eine solche Zelle kann unter Standardbedingungen im PC sporadisch zu Fehlern führen.

Erfindungsgemäß wird beim zweiten Anwendungsbeispiel durch den Einsatz des entsprechenden Testmodus die Signal Development Time variiert. Dann kann ein hochohmiger Bit-Leitungskontakt eine eindeutige Antwort zeigen: größere Werte der Signal Development Time reduzieren die Fehlerrate, kleinere Werte erhöhen sie.

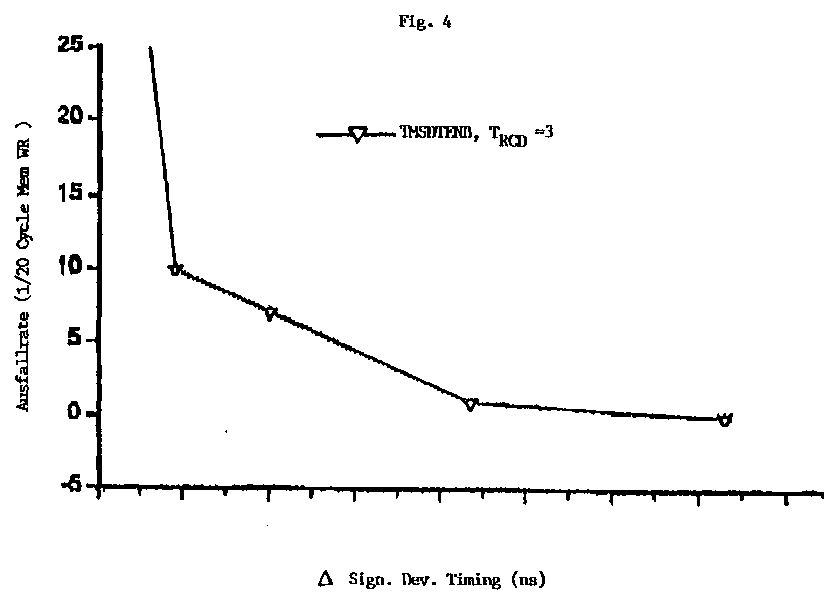

Die in Fig. 4 graphisch angegebenen Messergebnisse zeigen einen tatsächlichen Speicherausfall im PC, als dessen Ursache mit Hilfe der erfindungsgemäß durchgeführten Aktivierung des entsprechenden Signal-Development-Time-Testmodus ein hochohmiger Bit-Leitungskontakt ermittelt werden konnte. Die die Messergebnisse repräsentierende Kurve in Fig. 4 macht deutlich, dass ab einem um etwa 0,5 ns über den mit 0,0 angegebenen Standardwert die im Speichertestprogramm ermittelte Ausfallrate annähernd gleich Null ist und auch bei höheren Werten der Signal Development Time keine Ausfälle zu verzeichnen waren.

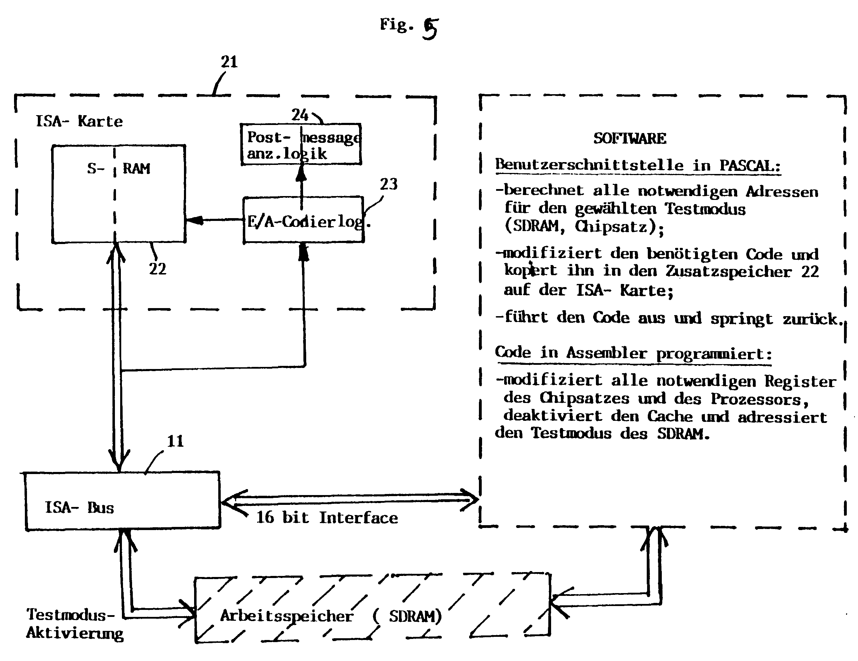

Das Blockdiagramm in Fig. 5 fasst die zur Aktivierung von Testmodi im Arbeitsspeicher 8 eines PCs während dessen normalen Betriebs vorgeschlagene Kombination einer auf einer Steckkarte 21 vorgesehenen Schaltungsanordnung, die beispielsweise an einem ISA-Bus-Steckplatz 12 (Fig. 1) einsteckbar ist, mit spezieller systemnaher Software zusammen.

Die als Beispiel angegebene Schaltungsanordnung auf der ISA-Karte 21 weist den Zusatzspeicher 22, der z. B. aus zwei 8-Bit-SRAM-Bausteinen mit insgesamt 16 Bit breitem Datenzugriff besteht, eine Adressen- und E/A-Ausgabecodierlogik 23 und eine Anzeigecodierlogik 24 auf. In dem mit "Software" in Fig. 5 bezeichneten Block sind die die Benutzerschnittstelle betreffenden Programme in der Hochsprache PASCAL programmiert. Dieser Programmcode berechnet alle notwendigen Adressen für den gewählten Testmodus, für SDRAM, Chipsatz, modifiziert den benötigten Code und kopiert ihn in den Zusatzspeicher 22, führt den Code aus und springt ins aufrufende Programm zurück. Der Aufruf des Testmodus erfolgt demnach im Hochsprachenprogramm unter MS DOS.

Der Code des Testmodus ist in Assembler programmiert. In diesem Assembler-Programm werden alle notwendigen Register des Chipsatzes und des Prozessors modifiziert, der CACHE-Speicher deaktiviert und der Testmodus des SDRAM adressiert.

In Fig. 5 sind alle für das erfindungsgemäße Verfahren nötigen neuen Funktionsblöcke gestrichelt eingerahmt. Der zu testende Arbeitsspeicher 8 (SDRAM) ist gestrichelt schräg schraffiert.

Die Erfindung ermöglicht erstmals den Einsatz aller in SDRAM-Chips implementierten Testmodi in Standard Personal Computern und mit Standardbetriebssystemen. Darüber hinaus bieten diese Testmodi erstmals die Möglichkeit, durch Variation verschiedener bausteininterner Parameter, wie z. B. interner Spannungen und Timings, in dem im üblichen Personal Computer eingesetzten SDRAM die eigentliche Ursache eines Fehlers zu analysieren. Mit der Fehleranalyse lassen sich zusätzlich Optimierungen am SDRAM-Chip durchführen und außerdem eine ermittelte Variation interner Parameter für ein endgültiges Design eines SDRAM-Chips verwenden.

## Patentansprüche

1. Verfahren zum Testen eines als Arbeitsspeicher im Personal Computer (PC) eingesetzten SDRAM-Speichers, in dem wenigstens ein vorbestimmter herstellerdefinierter interner Testmodus implementiert ist,
**gekennzeichnet durch**
folgende Schritte:
A) Speichern wenigstens einer zur Aktivierung und Durchführung wenigstens eines der internen Testmodi geeigneten Befehlsfolge im Maschinencode in einem vom Arbeitsspeicher separaten Zusatzspeicher;
B) im PC wird der Maschinencode aktiviert und der CACHE-Speicher abgeschaltet;
C) die CPU wird in den UNREAL-MODE versetzt, wobei die Datensegmentierung des Arbeitsspeichers aufgehoben wird;
D) im PC werden für eine Aktivierungssequenz des Testmodus im SDRAM vorbestimmte Einstellungen des PC-Chipsatzes durchgeführt;
E) benutzerdefiniert wird ein gewünschter Testmodus von den im SDRAM-Speicher implementierten Testmodi ausgewählt und daraufhin ein Lese-Zugriff auf den separaten Zusatzspeicher zur Ausführung der Befehlsfolge für die Aktivierung des Testmodus ausgeführt, wobei ;
F) der Testmodus durch eine bestimmte Sequenz von Kommandos und Adressen vom Speichercontroller an den SDRAM-Speicher aktiviert wird, die durch die Befehlsfolge im Zusatzspeicher gesteuert wird, und
H) Testergebnisse werden protokolliert.

2. Verfahren nach Anspruch 1,
**dadurch gekennzeichnet,**
dass in Schritt A) eine Befehlsfolge zur Aktivierung eines ersten chip-internen Testmodus zur Veränderung einer internen Spannung (V_{ref}) des SDRAM-Speicherchips gespeichert und in den Schritten B) bis G) dieser erste Testmodus aktiviert und ausgeführt wird.

3. Verfahren nach Anspruch 2,
**dadurch gekennzeichnet,**
dass der erste Testmodus von einem Standardwert der Referenzspannung (V_{ref}) ausgeführt wird.

4. Verfahren nach Anspruch 1,
**dadurch gekennzeichnet,**
dass im Schritt A) eine Befehlsfolge zur Aktivierung eines zweiten internen Testmodus zur Veränderung einer chip-internen Zeitdauer ("Signal Development Timing"), die die Zeitdauer zwischen dem Aktivieren der Wortleitung und dem Aktivieren des zugehörigen Sense-Verstärkers angibt, gespeichert und in den Schritten B) bis G) dieser zweite Testmodus aktiviert und ausgeführt wird.

5. Verfahren nach einem der Ansprüche 1 bis 4,
**dadurch gekennzeichnet**,
dass das Verfahren folgende weitere Schritte aufweist:
H) nach Ausführung des Testmodus in Schritt F) und Protokollierung der Testergebnisse in Schritt G) werden die im Schritt D) vorgenommenen Einstellungen des PC-Chipsatzes rückgängig gemacht;
I) die Datensegmentierung des Arbeitsspeichers wird durch Versetzen der CPU in den REAL-MODE wiederhergestellt;
K) der CACHE-Speicher wird wieder eingeschaltet, und
L) es erfolgt ein Rücksprung ins aufrufende Programm, wobei der SDRAM-Speicher im gewählten Testmodus bleibt, so dass dessen Auswirkung dem SDRAM-Speicher erhalten bleibt.

6. Vorrichtung zur Durchführung des Verfahrens nach einem der Ansprüche 1 bis 5,
**dadurch gekennzeichnet,**
dass der Zusatzspeicher (22) auf einer steckbaren Schaltungsplatte (21) vorgesehen ist.

7. Vorrichtung nach Anspruch 6,
**dadurch gekennzeichnet,**
dass die Schaltungsplatte (21) eine 16-Bit-ISA-Karte ist und als Zusatzspeicher zwei 8-Bit-SRAM-Bausteine mit einem insgesamt 16 Bit breiten Datenzugriff aufweist.
